# EUROPÄISCHE PATENTSCHRIFT

(11) **EP 0 780 005 B1**
(45) Veröffentlichungstag und Bekanntmachung des Hinweises auf die Patenterteilung: **18.11.1998**
(21) Anmeldenummer: 95929752.4
(22) Anmeldetag: 05.09.1995
(51) Int. Cl.: G06K 19/077

(54) **TRÄGERELEMENT FÜR INTEGRIERTEN SCHALTKREIS**
IC SUPPORT ELEMENT
ELEMENT DE SUPPORT POUR CIRCUIT INTEGRE

(30) Priorität: 06.09.1994 DE 4431754
(43) Veröffentlichungstag der Anmeldung: 25.06.1997
(73) Patentinhaber: SIEMENS AKTIENGESELLSCHAFT, 80333 München (DE)
(72) Erfinder: MUNDIGL, Josef, D-93182 Duggendorf (DE); KIRSCHBAUER, Josef, D-93476 Blaibach (DE)
(86) Internationale Anmeldenummer: DE9501200
(87) Internationale Veröffentlichungsnummer: WO9607983

(56) Entgegenhaltungen:
- EP-A- 0 376 062
- EP-A- 0 379 592
- EP-A- 0 581 284
- EP-A- 0 595 549
- DE-A- 4 319 878
- US-A- 4 931 991

## Beschreibung

Die Erfindung betrifft ein Trägerelement, insbesondere zum Einbau in eine Chipkarte, mit einem auf einem Leiterträger, der vom Fachmann üblicherweise als Leadframe bezeichnet wird, angeordneten und mit dessen Kontaktfahnen elektrisch verbundenen Halbleiterchip, wobei zumindest der Halbleiterchip und zu dessen Verbindung mit den Kontaktfahnen vorgesehene Bonddrähte von einer Kunststoffmasse derart umgeben sind, daß die Kontaktfahnen als leitende Verbindung zu dem Halbleiterchip aus der Kunststoffmasse herausragen.

Ein solches Trägerelement ist aus der EP 0 254 640 A1 bekannt. Dieses bekannte Trägerelement wird in eine Chipkarte eingesetzt, die von einem Lesegerät mittels mechanischer Kontakte über die Kontaktfahnen mit Energie versorgt wird. Auch der Datenfluß verläuft über die Kontaktfahnen mittels mechanischer Kontakte.

Aus der DE 41 15 065 C2 ist eine kontaktlose Chipkarte bekannt, bei der die Energie und Daten über eine Antennenspule, also über eine induktive Kopplung, übertragen werden. Hierbei sind die Enden der Antennenspule mit dem Halbleiterchip der Chipkarte verbunden, wobei die Chipkarte keine sonstigen Kontakte nach außen aufweist. Ein Test des Chips solcher berührungsloser Chipkarten ist dann nur über eine montierte Spule möglich.

Die Aufgabe vorliegender Erfindung ist es, ein Trägerelement anzugeben, das zum Einbau in eine kontaktlose Chipkarte geeignet ist, einen Test ohne angeschlossene Spule ermöglicht, sowie geeignet ist, eine Spule daran zu montieren.

Die Aufgabe wird gelöst durch ein Trägerelement gemäß Anspruch 1. Vorteilhafte Weiterbildungen der Erfindung sind in den Unteransprüchen angegeben.

Durch die erfindungsgemäße Ausbildung von Kontakt flächen auf einer der Oberflächen der Kunststoffumhüllung des Halbleiterchips durch die Kontaktfahnen ist ein elektrischer Zugang zum Chip mittels mechanischer Kontakte z. B. für Testzwecke möglich, ohne daß an die Verlängerung der Kontaktfahnen eine Antenne angeschlossen ist. Ein Test ist jedoch auch möglich, wenn die Antenne angeschlossen ist, jedoch muß diese aufgrund der erfindungsgemäßen Ausbildung nicht benutzt werden.

Wenn die Kontaktfahnenverlängerungen an gegenüberliegenden Seiten des Trägerelements angeordnet sind, kann das Trägerelement in vorteilhafter Weise direkt auf die Windungen einer planaren Spule gesetzt werden, und mit den Spulenenden kontaktiert werden, so daß die Spulenenden die Windungen nicht überlappen müssen, auf diese Weise ist eine leicht automatisierbare Herstellung der Verbindung Trägerelement - Spule möglich, die eine hohe Reproduzierbarkeit der Spulenwerte wie deren Güte erbringt.

Durch Ausbildung der Kontaktfahnenverlangerung mit unterschiedlichen Längen ist ebenfalls eine überlappungsfreie Kontaktierung der Spulenenden möglich, da die längere der Kontaktfahnenverlängerungen entweder über oder unter den Windungen geführt werden kann. Dabei ist es möglich, das Trägerelement nahe am Chipkartenrand oder gar in einer Ecke zu plazieren, so daß es weit weg von der durch Biegebeanspruchung am stärksten belasteten Mittellinie der Chipkarte angeordnet ist.

Die Erfindung wird nachfolgend anhand von Ausführungsbeispielen mit Hilfe von Figuren näher erläutert. Dabei zeigen:
- Figur 1 und 2: jeweils einen Querschnitt durch ein erfindungsgemäßes Trägerelement und
- Figur 3: eine räumliche Darstellung eines montierten Trägerelements.

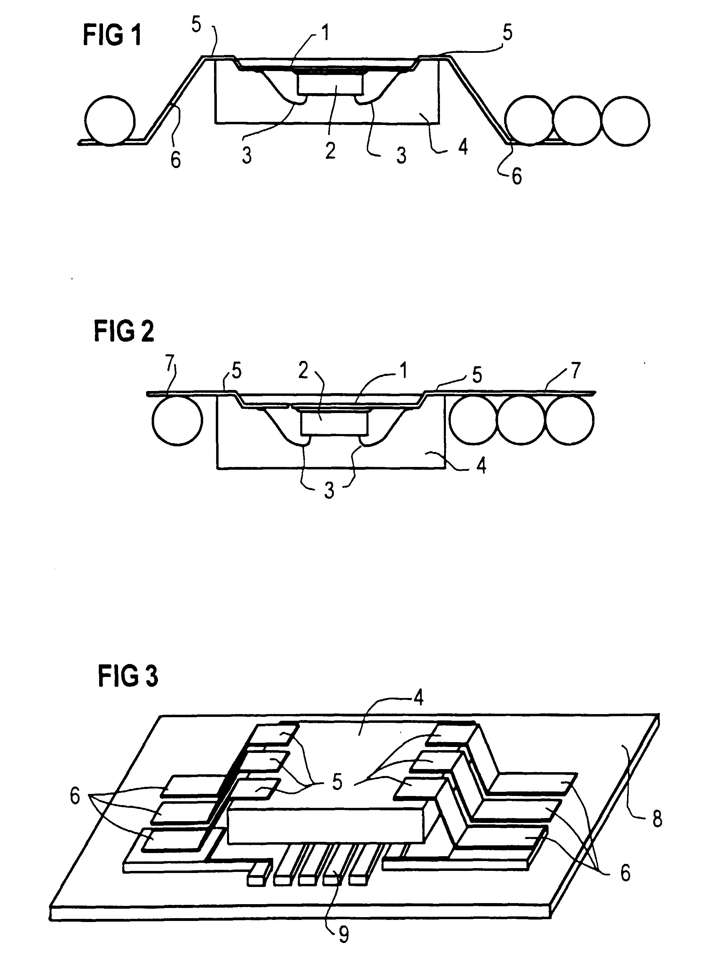

Gemäß der Figuren 1, 2 und 3 ist ein Halbleiterchip 2 auf einem Leitertrager 1 befestigt, beispielsweise geklebt, und mittels Bonddrähten 3 mit dessen Kontaktfahnen 5, 6 oder 5, 7 elektrisch leitend verbunden. Der Halbleiterchip 2 und die Bonddrähte 3 sind mit einer ein Gehäuse 4 bildenden Kunststoffmasse 4 umgossen. Die Kontaktfahnen des Leiterträgers 1 sind derart geformt, daß sie Kontakflächen 5 bilden, die an einer Oberfläche der Kunststoffmasse 4 angeordnet sind. Die Verlängerungen der Kontaktflächen 5 bilden Anschlüsse 6, 7 für die Enden einer Antennenspule. In Figur 1 sind die Kontaktfahnenverlängerungen zweimal abgewinkelt, so daß sie unterhalb der Antennenwindungen geführt werden können. In Figur 2 verlaufen die Verlängerungen der Kontakt flächen in der gleichen Ebene wie die Kontaktflächen, so daß sie oberhalb von Antennenwindungen geführt werden. Figur 3 zeigt eine besonders vorteilhafte Montage eines erfindungsgemäßen Trägerelements. Hierbei ist das Trägerelement direkt auf den Windungen 9 einer planaren Spule aufgebracht, und zwei der an gegenüberliegenden Seiten des Trägerelements angeordneten Kontaktfahnenverlängerungen sind mit den Enden der Spule verbunden. Auf diese Weise bildet das Trägerelement selbst die Überbrückung der Spulenwindungen. Damit ist eine besonders leicht automatisierbare und gut reproduzierbare Montagemöglichkeit gegeben. Die Antennenwindungen 9 können dabei als gedruckte Leitungen auf einem Karteninlet 8 realisiert sein. Der Halbleiterchip kann bei dem erfindungsgemäßen Trägerelement mittels der Kontaktflächen 5 sowohl bei montiertem Trägerelement als auch bei nicht montiertem Trägerelement problemlos mittels mechanischer Kontakte getestet werden.

## Patentansprüche

1. Trägerelement, insbesondere zum Einbau in eine Chipkarte, mit einem auf einem Leiterträger (1) angeordneten und mit dessen Kontaktfahnen (5,6;5,7) elektrisch verbundenen Halbleiterchip (2), wobei zumindest der Halbleiterchip (2) und zu dessen Verbindung mit den Kontaktfahnen (5,6;5,7) vorgesehene Bonddrähte (3) von einer Kunststoffmasse (4) derart umgeben sind, daß die Kontaktfahnen (5,6;5,7) als leitende Verbindung zu dem Halbleiterchip (2) aus der Kunststoffmasse (4) herausragen,
**dadurch gekennzeichnet,**
daß die Kontaktfahnen auf einer der Oberflächen der Kunststoffmasse (4) Kontaktflächen (5) bilden, wobei wenigstens zwei der Kontaktfahnen zusätzlich in Verlängerung der Kontaktflächen (5) Anschlüsse (6;7) für die Enden einer Antennenspule bilden.

2. Trägerelement nach Anspruch 1, **dadurch gekennzeichnet,** daß die Spulenanschlüsse (6;7) der wenigstens zwei Kontaktfahnen unterschiedliche Längen aufweisen.

3. Trägerelement nach Anspruch 1 oder 2, **dadurch gekennzeichnet,** daß die Spulenanschlüsse (6;7) der wenigstens zwei Kontaktfahnen an gegenüberliegenden Seiten des Trägerelements angeordnet sind.

4. Trägerelement nach Anspruch 1 oder 2, **dadurch gekennzeichnet,** daß die Spulenanschlüsse der wenigstens zwei Kontaktfahnen parallel zueinander angeordnet sind.

5. Trägerelement nach Anspruch 1 oder 2, **dadurch gekennzeichnet,** daß die Spulenanschlüsse (6;7) der wenigstens zwei Kontaktfahnen senkrecht zueinander angeordnet sind.

6. Trägerelement nach einem der Ansprüche 1 bis 5, **dadurch gekennzeichnet,** daß die Kontaktflächen (5) und die Spulenanschlüsse (7) der wenigstens zwei Kontaktfahnen in einer Ebene liegen.

7. Trägerelement nach einem der Ansprüche 1 bis 5, **dadurch gekennzeichnet,** daß die Kontaktflächen (5) und die Spulenanschlüsse (6) der wenigstens zwei Kontaktfahnen in unterschiedlichen Ebenen liegen.

## Claims

1. Carrier element, in particular for incorporation into a chip card, having a semiconductor chip (2) which is arranged on a conductor carrier (1) and is electrically connected to its contact tabs (5, 6; 5, 7), at least the semiconductor chip (2) and bond-wires (3) provided for its connection to the contact tabs (5, 6; 5, 7) being surrounded by a plastics compound (4) in such a way that the contact tabs (5, 6; 5, 7) project out of the plastics compound (4) as a conductive connection to the semiconductor chip (2), characterized in that the contact tabs form contact areas (5) on one of the surfaces of the plastics compound (4), at least two of the contact tabs additionally forming, in extension of the contact areas (5), connections (6; 7) for the ends of an antenna coil.

2. Carrier element according to Claim 1, characterized in that the coil connections (6; 7) of the at least two contact tabs have different lengths.

3. Carrier element according to Claim 1 or 2, characterized in that the coil connections (6; 7) of the at least two contact tabs are arranged on opposite sides of the carrier element.

4. Carrier element according to Claim 1 or 2, characterized in that the coil connections of the at least two contact tabs are arranged parallel to each other.

5. Carrier element according to Claim 1 or 2, characterized in that the coil connections (6; 7) of the at least two contact tabs are arranged at right angles to each other.

6. Carrier element according to one of Claims 1 to 5, characterized in that the contact areas (5) and the coil connections (7) of the at least two contact tabs lie in one plane.

7. Carrier element according to one of Claims 1 to 5, characterized in that the contact areas (5) and the coil connections (6) of the at least two contact tabs lie in different planes.

## Revendications

1. Elément support, notamment pour être monté dans une carte à puce, comportant une puce (2) à semi-conducteurs disposée sur un support (1) conducteur et reliée électriquement à des oreilles (5, 6 ; 5, 7) de contact de celui-ci, au moins la puce (2) à semi-conducteurs et des fils (3) de bonding prévus pour la liaison de celle-ci aux oreilles (5, 6 ; 5, 7) de contact étant enrobés d'une masse (4) de matière plastique de sorte que les oreilles (5, 6; 5, 7) de contact font saillie hors de la masse (4) de matière plastique en tant que liaison conductrice vers la puce (2) à semi-conducteurs,
caractérisé en ce que
les oreilles de contact forment sur une des faces de la masse (4) de matière plastique des surfaces (5) de contact, au moins deux des oreilles de contact formant dans le prolongement des surfaces (5) de contact des bornes (6, 7) pour les extrémités d'une bobine antenne.

2. Elément support suivant la revendication 1, caractérisé en ce que les bornes (6, 7) de bobine des au moins deux oreilles de contact ont des longueurs différentes.

3. Elément support suivant la revendication 1 ou 2, caractérisé en ce que les bornes (6, 7) de bobine des au moins deux oreilles de contact sont disposées sur des côtés opposés de l'élément support.

4. Elément support suivant la revendication 1 ou 2, caractérisé en ce que les bornes de bobine des au moins deux oreilles de contact sont disposées parallèles l'une à l'autre.

5. Elément support sur la revendication 1 ou 2, caractérisé en ce que les bornes (6, 7) de bobine des au moins deux oreilles de contact sont disposées perpendiculairement l'une à l'autre.

6. Elément support suivant l'une des revendications 1 à 5. caractérisé en ce que les surfaces (5) de contact et les bornes (7) de bobine des au moins deux oreilles de contact se trouvent dans un plan.

7. Elément support suivant l'une des revendications 1 à 5, caractérisé en ce que les surfaces (5) de contact et les bornes (6) de bobine des au moins deux oreilles de contact se trouvent dans des plans différents.
